**Europäisches Patentamt**

**European Patent Office**

**Office européen des brevets**

(19)

(11) **EP 1 530 087 A2**

(12) **EUROPEAN PATENT APPLICATION**

(43) Date of publication:
**11.05.2005 Bulletin 2005/19**

(51) Int Cl.⁷: **G03F 7/20**

(21) Application number: **04026463.2**

(22) Date of filing: **08.11.2004**

(84) Designated Contracting States:
**AT BE BG CH CY CZ DE DK EE ES FI FR GB GR HU IE IS IT LI LU MC NL PL PT RO SE SI SK TR**
Designated Extension States:
**AL HR LT LV MK YU**

(30) Priority: **10.11.2003 JP 2003380075**

(71) Applicant: **CANON KABUSHIKI KAISHA Ohta-ku, Tokyo (JP)**

(72) Inventor: **Tsuji, Toshihiko Tokyo (JP)**

(74) Representative:
**Leson, Thomas Johannes Alois, Dipl.-Ing. Tiedtke-Bühling-Kinne & Partner GbR, TBK-Patent, Bavariaring 4 80336 München (DE)**

(54) **Illumination optical system and exposure apparatus**

(57) Disclosed is an illumination optical system and an exposure apparatus having the same. In one aspect, the illumination optical system illuminates a surface to be illuminated, with light from a light source, wherein it includes a mirror having a reflection surface, and a stop having an aperture surface disposed approximately perpendicularly to the reflection surface of the mirror.

**FIG.1**

**Description**

FIELD OF THE INVENTION AND RELATED ART

This invention relates generally to an illumination optical system and an exposure apparatus using the same. More particularly, the invention concerns an illumination optical system which uses, as exposure light, light of X-ray region or light of extreme ultraviolet (EUV) region in a wavelength range of 200 nm to 10 nm, and an exposure apparatus using the same for exposure of a workpiece such as monocrystal substrate for semiconductor wafer or glass substrate for liquid crystal display, for example.

In order to meet requirements for further reduction in size of a device pattern, the wavelength of light used in exposure apparatuses as exposure light has been shortened more and more.

In recent years, many proposals have been made to an exposure apparatus using extreme ultraviolet (EUV) light or X-rays as exposure light (e.g. Japanese Laid-Open Patent Application, Publication No. 10-70058 corresponding to U.S. Patent No. 6,504,896; Japanese Laid-Open Patent Application, Publication No. 2003-045774 corresponding to Published U.S. Patent Application, Publication No. 2003/31017; and Japanese Laid-Open Patent Application, Publication No. 2003-045784 corresponding to Published U.S. Patent Application, Publication No. 2003/31017).

In exposure apparatuses using EUV light or X-rays (particularly, light of 20 nm to 5 nm) as exposure light, an illumination optical system for illuminating a mask (reticle) with light from a light source could not include a transmission type (refractive) optical system. Generally, a reflection optical system having a reflective multilayered film is used.

The reflectance of a multilayered film mirror usable in such reflection optical system is about 67%. In order to minimize the decrease of utilization efficiency of the light from the light source, within the illumination optical system, the number of mirrors constituting the illumination optical system should be made smaller.

However, for good illumination, for example, in order to well define an effective light source, the space (pupil plane) where an aperture stop is to be placed must be maintained, and to this end the number of mirrors constituting the illumination optical system has to be increased. This raises a problem of a decrease of light utilization efficiency of the illumination optical system, that is, the transmissivity of the whole system).

SUMMARY OF THE INVENTION

It is accordingly an object of the present invention to provide an illumination optical system and/or an exposure apparatus having the same, by which good illumination is assured with use of a relatively small number of mirrors.

In accordance with an aspect of the present invention, there is provided an illumination optical system for illuminating a surface to be illuminated, with light from a light source, comprising: a mirror having a reflection surface; and a stop having an aperture surface disposed perpendicularly or approximately perpendicularly to the reflection surface of said mirror.

In accordance with another aspect of the present invention, there is provided an illumination optical system for illuminating a surface to be illuminated, with light from a light source, comprising: a mirror having a reflection surface; and a stop disposed adjacent (or in contact with) the reflection surface of said mirror, wherein light from the light source passes through an opening defined by the reflection surface of said mirror and said stop.

An illumination optical system for illuminating a surface to be illuminated, with light from a light source, in a further aspect of the present invention, may comprise an optical unit including a mirror, having a reflection surface, and a stop disposed adjacent or in contact with the reflection surface of the mirror, wherein light from the light source is restricted by the stop as if it is restricted by a combination of the stop and a virtual image of the same provided by the reflection surface of the mirror, and wherein the light so restricted is projected from the optical unit.

An illumination optical system for illuminating a surface to be illuminated, with light from a light source, in a still further aspect of the present invention, may comprise a mirror, having a reflection surface, and a stop having an opening, wherein the stop is disposed adjacent (or in contact with) the reflection surface of the mirror so that both of light before being incident on the mirror and light after being reflected by the mirror can pass through the opening from the same side.

An illumination optical system for illuminating a surface to be illuminated, with light from a light source, in a yet further aspect of the present invention, may comprise a mirror and a stop, wherein the stop is disposed adjacent (or in contact with) the reflection surface of the mirror so that both of light before being incident on the mirror and light after being reflected by the mirror can be blocked at the same side of the stop.

An illumination optical system for illuminating a surface to be illuminated, with light from a light source, in a yet further aspect of the present invention, may comprise a mirror and a stop disposed adjacent (or in contact with) the reflection surface of the mirror, wherein a combination of the stop and a virtual image of the stop provided by the reflection surface of the mirror defines the distribution shape of an effective light source.

An illumination optical system for illuminating a surface to be illuminated, with light from a light source, in a yet further aspect of the present invention, may comprise a mirror and a stop having an opening and being disposed adjacent (or in contact with) the reflection surface of the mirror, wherein the shape of the opening is approximately the same as a shape of a half of a distribution shape of an effective light source, when the distribution shape of the effective light source is divided symmetrically with respect to a predetermined axis.

These and other objects, features and advantages of the present invention will become more apparent upon a consideration of the following description of the preferred embodiments of the present invention taken in conjunction with the accompanying drawings.

BRIEF DESCRIPTION OF THE DRAWINGS

Figure 1 is a schematic view of an exposure apparatus according to a first embodiment of the present invention.

Figure 2A is a schematic view of a reflection type integrator having a plurality of convex (outer) cylindrical surfaces.

Figure 2B is a schematic view of a reflection type integrator having a plurality of concave (inner) cylindrical surfaces.

Figure 3 is a sectional view, illustrating a sectional shape of a reflection type integrator.

Figure 4 is a schematic view for explaining an angular distribution of light reflected by a cylindrical surface.

Figure 5 is a schematic view for explaining an arcuate region formed by light reflected by a cylindrical surface.

Figure 6 is a schematic view for explaining a case where parallel light is incident on a reflection type integrator.

Figure 7 is a schematic view for explaining disposition of a reflection type integrator and an aperture stop.

Figure 8A is a schematic view, showing the shape of an effective light source when no aperture stop is placed.

Figure 8B is a schematic view, showing the shape of an effective light source when an aperture stop is placed.

Figures 9A, 9B, 9C and 9D are schematic views, respectively, showing examples of aperture stops for changing the illumination modes.

Figure 10 is a schematic view of an arcuate slit.

Figure 11 is a flow chart for explaining sequence of device manufacturing processes.

Figure 12 is a flow chart for explaining details of a wafer process included in the procedure of Figure 11.

DESCRIPTION OF THE PREFERRED EMBODIMENTS

Preferred embodiments of the present invention will now be described with reference to the attached drawings.

[Embodiment 1]

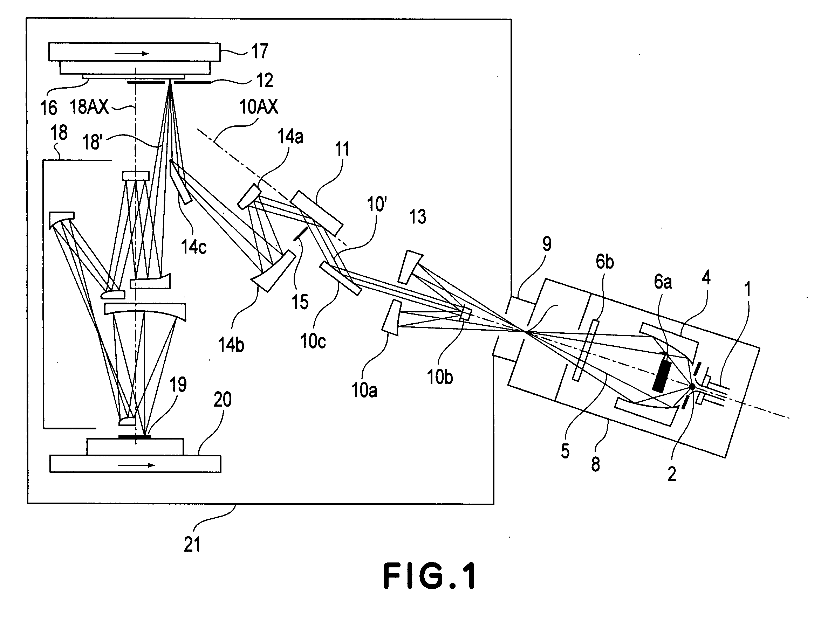

Figure 1 is a schematic view of a main portion of a first embodiment of the present invention. Denoted in Figure 1 at 1 is an electric discharging header, and denoted at 2 is a plasma light emission point from which EUV light can be emitted. The light emitted from the plasma emission point is collected by a collecting mirror 4. Denoted at 5 is EUV light flux as collected by the mirror 4. Denoted at 6a is a filter for removing scattered particles (debris) from the plasma, and denoted at 6b is a wavelength filter for removing light of wavelengths other than the EUV light. Denoted at 7 is a pinhole-like aperture disposed adjacent the light collection point of the collecting mirror 4. These members are accommodated in a vacuum container 8, and they constitute a light source unit. There is a connector 9 for coupling the light source unit and a major assembly of the exposure apparatus, while keeping the vacuum state.

Next, components of an illumination optical system will be described. Denoted at 10a and 10b is a parallel-transforming optical system (first optical unit) which comprises a concave surface mirror and a convex surface mirror and which serves to receive EUV light from the light source and passed through the aperture 7 and to transform it into approximately parallel light. Denoted at 10c is a mirror. Denoted at 11 is an integrator having a plurality of cylindrical reflection surfaces. To the reflection surfaces of the integrator, there is an aperture stop 15 having its aperture surface disposed approximately perpendicularly to the integrator reflection surface. This is an important feature of the illumination optical system according to this embodiment of the present invention. The aperture stop has a function for regulating the distribution shape of the effective light source, and also to regulate the angular distribution of light that illuminate each point on the surface of a mask (reticle) 16 which is the surface to be illuminated.

Denoted at 14a and 14b are elements that constitute an arcuate optical system (second optical unit) for collecting light from the integrator 11 into an arcuate shape. Denoted at 14c is a flat mirror for deflecting the image-side light of the arcuate optical system upwardly so that the light is incident on the reflection type mask 16 at a predetermined angle. Just before the reflection type mask 16, there is a slit 12 having an arcuate opening. Those members described above constitute the illumination optical system.

The reflection type mask 16 is held by a mask stage 17. Denoted at 18 is a projection optical system, comprising a plurality of multilayered-film mirrors. It is a co-axial system, and it is designed to be non-telecentric on the object side and telecentric on the image side. Denoted at 19 is a wafer being coated with a photosensitive material, and denoted at 20 is a wafer stage for holding the wafer 19. Denoted at 21 is a vacuum container for maintaining the whole optical system in a vacuum, to thereby prevent attenuation of the EUV light.

A pulsed large electric current excited by a pulse power source (not shown) which is an electric current supplying source is applied to the discharging header 1 and is discharged therefrom. In response to this energy, high energy density plasma 2 is produced from a plasma medium between the electrodes. As regards the plasma medium, Xe gas may be used, for example. It is introduced into between the electrodes of the discharging head 1, while the flow rate is controlled. Due to thermal radiation from this plasma 2, EUV light of a wavelength of about 13.5 nm is produced. The light source which is based on generation of plasma such as described above is called "electric-discharge excited plasma type EUV light source" or "discharge produced plasma light source". According to the method of discharge excitement used, there are many types such as Z-pinch, plasma-focus, capillary discharge, and so on.

In this embodiment, Xe gas is used as the plasma medium. However, steams of Sn, for example, may be used as the plasma medium and, by which, an EUV light source having an increased light output power of about 13.5 nm can be provided.

In place of the discharge produced plasma type, a laser excited plasma EUV light source in which high-power pulse laser is collected and projected on a plasma medium to produce plasma may be used. As a further alternative, an undulator is used as EUV light source, within the scope of the present invention.

The EUV light emitted from the plasma light emission point 2 is collected by the collecting mirror 4 which comprises a rotational elliptical mirror, for example, whereby EUV light is extracted. By means of the filter 6a, scattered particles (debris) directly scattered from the plasma and from around it forwardly are removed. Also, by means of the filter 6b, as required, unwanted wavelength components, unnecessary for the EUV exposure, are removed. Then, the light is collected at the position of the pinhole-like aperture 7 which is provided at the boundary between the vacuum container 8 containing the plasma light source and the vacuum container 21 for the exposure apparatus main assembly. The vacuum container 8 of the light source and the vacuum container 21 of the exposure apparatus main assembly are coupled to each other by means of the connector 9, and operating exhaust is carried out as required.

The EUV light passed through the aperture 7 is transformed by the parallel-transforming optical system that comprises a concave mirror 10a having an opening at its central portion and a convex mirror 10b of relatively small diameter, into approximately parallel light 10'.

Here, the collecting mirror 4 and the mirrors 10a and 10b described above have a reflective multilayered film for efficient reflection of EUV light. Since they absorb a portion of the radiation energy from the high-temperature plasma 2, the temperature of them becomes high during the exposure. In consideration of this, as regards the material, a material such as metal, for example, having good heat conductivity is used and, additionally, cooling means (not shown) such as water cooling, for example, is provided such that they can be cooled continuously during the exposure.

Although it will not be described specifically, each mirror used in the optical system has a reflective multilayered film formed on its reflection surface, for efficient reflection of EUV light. As required, these mirrors may be made of a material such as metal, for example, having good heat conductivity, and cooling means may be provided therefor.

The EUV light 10' having been transformed into approximately parallel light is deflected by the mirror 10c and it is incident on the integrator 11 having a plurality of cylindrical mirrors. The EUV light incident on the integrator 11 is divided by the cylindrical mirrors and is diverged thereby. After passing through the aperture stop 15 which will be described later, the diverged light is collected into an arcuate shape by means of the arcuate optical system having mirrors 14a and 14b, by which an arcuate illumination region having uniform illuminance distribution can be produced at the opening of the arcuate slit 12.

Here, the principle of uniformly illuminating the arcuate region with the use of integrator 11 will be explained, taking in conjunction with different drawings.

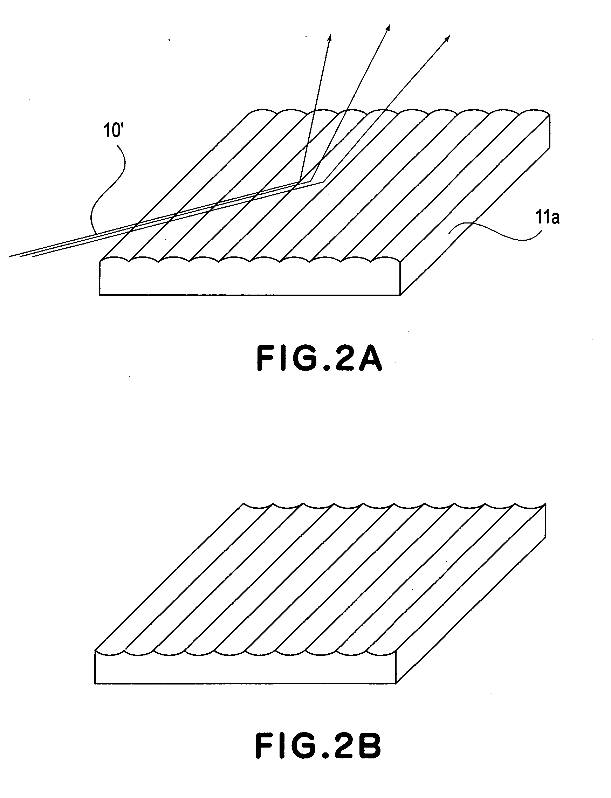

Figure 2A is a schematic and perspective view, illustrating a case where parallel light is incident on a reflection type convex (outer) cylindrical-surface integrator 11 having a plurality of convex cylindrical surfaces. Approximately parallel EUV light 10' described above is projected thereon, along a direction as illustrated. Figure 2B is a schematic and perspective view of a reflection type concave (inner) cylindrical-surface integrator with a plurality of concave cylindrical surfaces, having a similar function as of the integrator of Figure 2A. The integrator 11 shown in Figure 1 is a reflection type convex cylindrical surface integrator such as shown in Figure 2A. However, it may be a reflection type concave cylindrical surface integrator such as shown in Figure 2B or, alternatively, it may be a combination of these integrators.

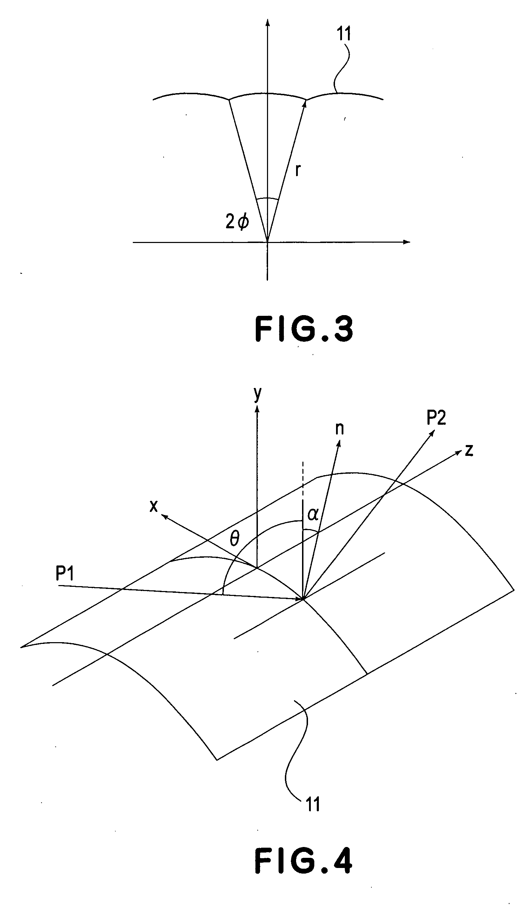

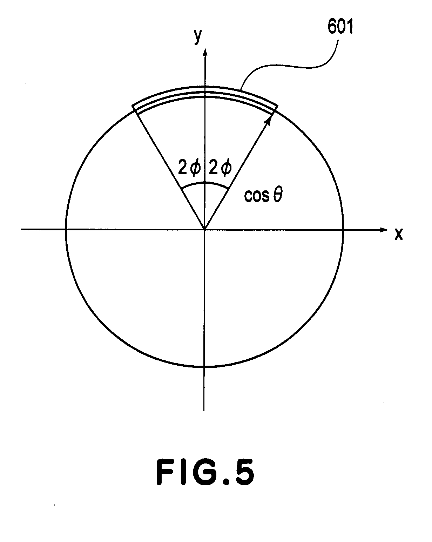

Figure 3 is a schematic and sectional view of a reflection type convex cylindrical surface integrator. Figure 4 is a schematic view for explaining reflection of EUV light at the cylindrical surface of a reflection type convex cylindrical surface integrator. Figure 5 is a schematic view for explaining angular distribution of EUV light being reflected by a cylindrical surface of a reflection type convex cylindrical surface integrator. In these drawings, reference numeral 11 denotes a reflection type convex cylindrical surface integrator.

As shown in Figure 2A, when approximately parallel EUV light 10' is incident on the integrator 11 having a plurality of cylindrical surfaces, a secondary light source of linear shape is produced adjacent the surface of the integrator and, also, the angular distribution of EUV light emitted from this secondary light source has a conical surface shape. Thus, by reflecting the EUV light with a reflection mirror having a focal point at that secondary light source position and by irradiating the reflection mask or a surface being conjugate with the reflection mask, arcuate-shaped illumination is enabled.

For explanation of the function of a reflection type integrator having a plurality of cylindrical surfaces, the action of reflection light as parallel light is incident on a single cylindrical surface will be described first, by reference to Figure 4.

Here, a case wherein parallel light is incident on a single cylindrical surface at an angle è with respect to a plane perpendicular to the central axis of the cylindrical surface, will be considered.

If the light-ray vector of the incident parallel light is denoted by

$$P1 = (0, -\cos è, \sin è)$$

and the vector of the normal to the reflection surface of cylindrical shape is denoted by

$$n = (-\sin á, \cos á, 0),$$

then the light-ray vector of the reflected light is

$$P2 = (-\cos è \sin 2á, \cos è \cos 2á, \sin è).$$

By plotting light-ray vectors of reflected light in a phase space, a circle having a radius $\cos è$ such as shown in Figure 5 will be obtained on the x-y plane. Namely, the reflected light is diverged light of conical surface shape, and a secondary light source is present adjacent the apex of the conical surface. If the cylindrical surface of the integrator is concave, the secondary light source is present outside the reflection surface as a real image. If it is convex, the secondary light source is present inside the reflection surface as a virtual image. Also, as shown in Figure 3, if the reflection surface is limitedly present in a portion of a cylindrical surface and it has a central angle 2ø, as shown in Figure 5 the range of presence of the light-ray vector P2 of the reflection light is an arcuate 501 with central angle 4ø upon the x-y plane.

Next, a case where a rotational paraboloid mirror having a focal length f is disposed with its focal point placed at the position of a secondary light source formed as a result of incidence of parallel light on a cylindrical reflection mirror such as described above as well as the surface to be illuminated is disposed at a position spaced by f from this reflection mirror, will be considered. The light emitted from the secondary light source is divergent light of conical surface shape and, after being reflected by the reflection mirror having a focal length f, it is transformed into parallel light. Hence, the reflection light is a sheet-like beam of arcuate sectional shape with a radius $f \times \cos è$ and a central angle 4ø. Thus, as shown in Figure 5, only an arcuate region 501 on the surface to be illuminated, that has a radius $f \times \cos è$ and a central angle 4ø, can be illuminated.

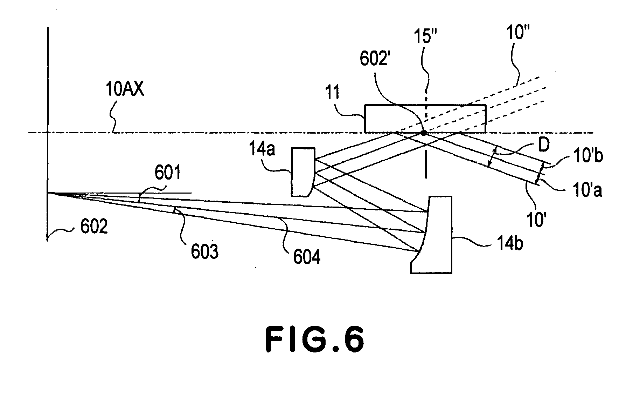

While the foregoing description has been made with reference to only one cylindrical reflection mirror, the following description will be made in conjunction with Figure 6 and with reference to a case where parallel light 10' having a certain beam diameter is incident, along the direction illustrated in Figure 1, upon an integrator 11 having a wide area and having a number of cylindrical surfaces arrayed in parallel to each other.

In Figure 6, denoted at 11 is the integrator described above, and denoted at 14a and 14b are convex mirror and a concave mirror with a spherical or aspherical surface, respectively, each having a reflective multilayered film formed thereon. The mirrors 14a and 14b constitute an arcuate optical system (second optical unit). Denoted at 602 is an image plane (surface to be illuminated), and this plane is equivalent to the mask 16 surface of Figure 1. The arcuate optical system has an imaging function for forming an arcuate illumination region on this plane, in a manner well suited to the projection optical system 18.

The arcuate optical system is a coaxial system taking an axis 10AX, placed approximately on the surface of the integrator 11, as a central symmetrical axis. It is arranged so that the center 602' of a light irradiating region upon the integrator 11 and the image plane 602 are placed approximately in Fourier transform surface relation with each other. More specifically, position 602' approximately corresponds to the pupil plane of the image plane 602, and an aperture stop 15 to be described later is placed at this position. With this arrangement, when approximately parallel EUV light 10' is incident on the integrator 11 as shown in the drawing, it is collected into an arcuate shape adjacent the image plane 602.

It should be noted here that the structure is non-telecentric at the image side and also that the incidence angle 601 of the principal ray 604 to the image plane 602 (i.e. the angle defined between the principal ray 604 and the optical axis 10AX of the arcuate optical system) is set to be approximately equal to the tilt angle, with respect to the normal to the mask surface, of a corresponding object-side principal ray of the projection optical system 18. In other words, the angle defined between the mask-side principal ray of the arcuate optical system and the optical axis AX, corresponding to each position within the illumination region of the reflection type mask, is set to be approximately equal to the angle defined between the mask-side principal ray of the projection optical system and the normal to the mask surface. In the case of this embodiment, the incidence angle is set about 6 deg., and it is equal to the angle defined between a corresponding principal ray at the mask side of the projection optical system and the normal to the mask surface. Furthermore, good correction is accomplished with regard to blur on the image side and, in design, the spot diameter on the image plane is set to be not greater than 5 mm, more preferably, not greater than 1 mm.

The incidence angle of the EUV light principal ray on the mirrors 14a and 14b, constituting the arcuate optical system, is set low, more specifically, not greater than 20 deg. As compared with the structure wherein a rotational paraboloid mirror or the like is used to make the incidence angle high, this arrangement makes it sure to reduce the amount of blur to be produced when light is collected at the image plane 602, such that the efficiency of light collection to the arcuate illumination region is improved. This makes it possible to suppress the loss of light due to eclipse by the arcuate slit 12 to be described later, and the illumination system efficiency is improved significantly.

In the arcuate optical system shown in Figure 1, the structure is so arranged that, when the image-side light is deflected upwardly by the plane mirror 14c toward the reflection mask 16c, the orientation of the arc of the arcuate illumination formed by the reflection is reversed and also that the arc center is registered with the point of intersection between the central axis 18AX of the projection optical system 18 and the reflection mask surface. Then, by setting the incidence angle 601 in the manner described above, it is assured that the image-side principal ray 604 of the arcuate optical system and the corresponding principal ray of the object-side light 18' of the projection optical system 18 are registered with each other while taking the reflection mask 16 as a reflection surface.

The angular distribution of light reflected by a reflection mirror having a large number of cylindrical surfaces arrayed in parallel to each other, is unchanged from the case of single cylindrical surface described hereinbefore. Thus, the light incident on a single point upon the image plane 602 reaches there from the whole irradiation region on the reflection mirror having many cylindrical surfaces arrayed in parallel to each other. Here, if the light beam diameter of the approximately parallel EUV light 10' is D, and the focal length of the arcuate optical system is f, the angular extension (i.e. collection NA) 603, when it is denoted by ã, is ã = D/f.

Here, in the arcuate illumination region, the uniformness of illuminance is accomplished by that, with respect to a direction along the arc, light fluxes from the cylindrical surfaces of the integrator 11 are superposed one upon another. Thus, with this arrangement, efficient and uniform arcuate illumination is ensured.

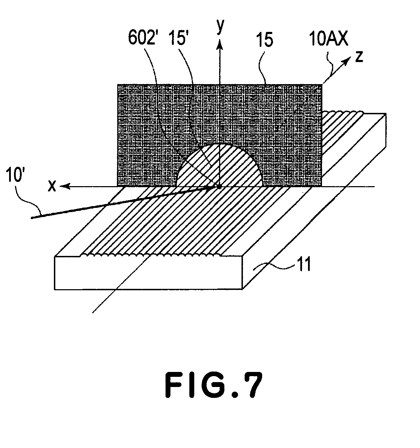

Next, referring to Figures 7 and 6, the optical unit constituted by the aperture stop 15 and the integrator 11 will be described in greater detail. Figure 7 is a schematic view, illustrating placement of the aperture stop 15 and the integrator 11. In this drawing, reference numeral 10' denotes the direction of the principal ray of the EUV light impinging on the integrator 11. Position at 602' is approximately at the center of the pupil plane of the arcuate optical system described hereinbefore. Taking this point 602 as an origin, x-y-z coordinate system is described. Here, z axis is registered with the co-axis 10AX of the arcuate optical system described hereinbefore, and it is approximately parallel to the generating line of the cylindrical surface of the integrator 11 surface.

The aperture stop 15 has an aperture surface 15' which is disposed approximately perpendicularly to the reflection surface of the integrator 11, where a number of cylindrical surfaces are arrayed. Also, the aperture surface is disposed approximately perpendicularly to the above-described co-axis 10AX. Furthermore, the bottom side of the aperture stop is approximately registered with the reflection surface of the integrator 11. Here, the aperture stop illustrated in detail in the drawing is an example of an aperture for standard illumination mode, not for an illumination mode for modified illumination. In this embodiment, it is an important feature that the shape of opening of the aperture stop placed on the pupil plane is semicircular shape as illustrated in the drawing. It is to be noted that this aperture stop is demountably inserted into the light path. Furthermore, as will be described later, when modified illumination in which the distribution shape of effective light source is ring-like or quadrupole shape is to be carried out as well, an aperture stop with an opening having a shape approximately the same as the distribution shape of a half of the effective light source distribution shape, as the same is bisected symmetrically with respect to a predetermined axis (that corresponds to the bottom side of the aperture stop 15), may be disposed there.

Next, referring to Figure 6, how the aperture stop 15 restricts a portion of the light will be explained. When approximately parallel light 10' is incident on the reflection surface of the integrator 11 at a relatively high incidence angle (e.g. 7 deg.), the incident light is restricted in the sense that a portion of the light is blocked by the semicircular opening of the aperture stop 15. On the other hand, considering a virtual image of the light 10' with respect to the above-described reflection surface, it can be depicted as light 10", broken lines in the drawing. It can be said that this light as well is restricted by a virtual image 15" of the aperture stop 15 with respect to the integrator 11 reflection surface. Considering the aperture stop 15 and its virtual image 15" in combination, it is seen that this arrangement is equivalent to that an aperture stop having a circular opening corresponding to a desired effective light source shape. In other words, the shape of the opening to be formed a combination of one 15" defined by folding back the aperture opening 15 symmetrically with respect to the reflection surface of the integrator and one defined by the aperture opening 15 before folding it back, is approximately the same as a desired effective light source distribution shape.

Alternatively, it may be regarded such that a lower half 10'a of the light flux 10' is partially blocked and thus restricted by the light-source side (incidence plane side) surface of the aperture stop 15 before it impinges on the integrator 11, whereas an upper half 10'b of the light flux 10' is partially blocked and thus restricted by the light-source side surface of the aperture stop 15 only after it is reflected by the integrator 11.

As a further alternative, it may be regarded such that the lower half 10'a of the light flux 10' is incident on the opening of the aperture stop 15 from the light source side before it is incident on the integrator 11, whereas the upper half 10'b of the light flux 10' is incident on the opening of the aperture stop 15 from the light source side only after it is reflected by the integrator 11.

In this embodiment, the aperture surface 15' is disposed perpendicularly to the reflection surface of the integrator 11. However, for precise adjustment of the effective light source distribution, the aperture surface 15' may be disposed with small tilt with respect to the integrator reflection surface, rather than completely perpendicularly thereto. Furthermore, for enabling adjustment of the effective light source distribution or telecentricity, for example, a driving mechanism (not shown) may be provided adjacent the aperture stop 15 so as to adjust the angle of the aperture surface of the aperture stop 15 with respect to the mirror reflection surface.

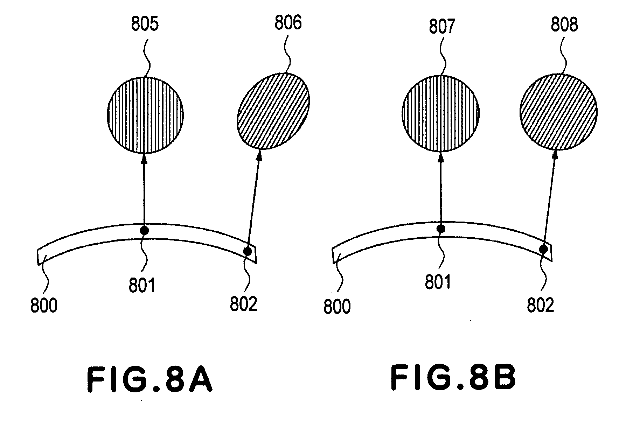

As described above, even if the shape of the opening of the aperture stop is semicircular, by disposing it with reference to the reflection surface of the integrator in the manner shown in Figure 7, the effective light source distribution (i.e. a light intensity, distribution on the pupil plane of the projection optical system or on the pupil plane of the illumination optical system) can be circular at an arbitrary position inside the arcuate illumination region. Figures 8A and 8B illustrate this. In these drawings, denoted at 800 is an arcuate illumination region defined on a wafer 19 surface, and points at 801 and 802 depict the observation positions for the effective light source, at a central portion and an end portion of the arc, respectively.

Specifically, Figure 8A illustrates the shape of effective light source in a case where the above-described aperture stop 15 is not provided. Although the distribution is circular as 805 at the central portion 801 of the arcuate region, the distribution is gradually deformed with the position shifted toward the end of the arcuate region, because there is no aperture stop. At the end portion 802 of the arcuate region, the effective light source has an elliptical shape such as shown at 806.

The effective light source distribution as observed at an arbitrary point in the illumination region represents the angular distribution of light being incident on that point conically with a certain numerical aperture (NA). If this is asymmetric such as at 806, it means that there is asymmetry in the exposure NA. Since this is a serious factor that causes adverse effect on the resolution performance, it would be never allowable.

On the other hand, Figure 8B illustrates the effective light source shape in a case where the above-described aperture stop 15 is provided. At positions 801 and 802, the effective light source distribution has a complete round circle such as shown at 807 and 808, respectively. Thus, uniformness of exposure NA is accomplished.

Oblique lines illustrated in the effective light source distributions 805 - 807 mean that the secondary light source produced by the integrator 11 comprises a large number of linear secondary light sources. The spacing of these lines depends on the width of cylindrical surfaces arrayed on the reflection surface of the integrator 11. The density of the effective light source can be made richer by narrowing the above-described line spacing, this being done by increasing the number of cylindrical surfaces by narrowing the width of each cylindrical surface with respect to the width of the integrator.

Next, how to change a coherence factor ó or how to perform deformed illumination such as ring-zone illumination, for example, on the basis of switching the aperture stop 15, will be described. Since the aperture surface of the aperture stop 15 and the pupil plane of the projection optical system 18 are in optically conjugate relationship with each other, the opening pattern of the aperture stop 15, namely, the transmitted pattern of the light, just corresponds to the light source image (i.e. effective light source distribution) formed on the pupil plane of the projection optical system.

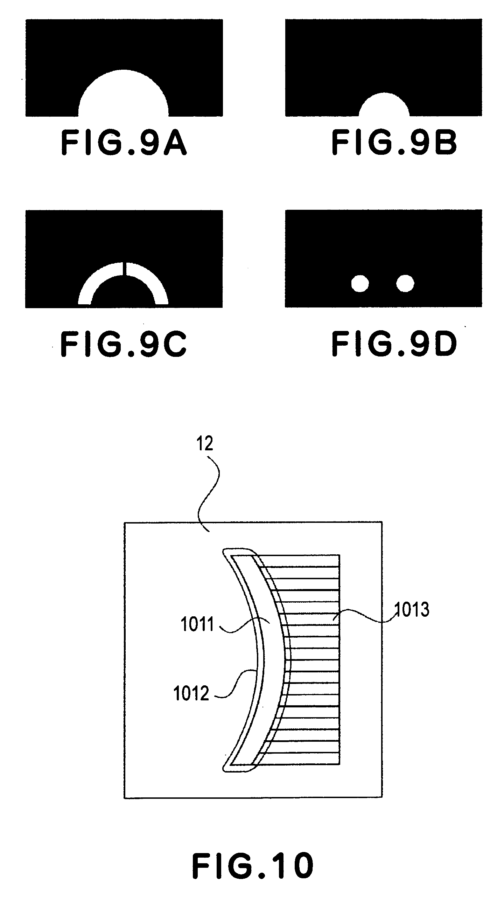

Figures 9A - 9D show examples of the opening shape to be formed on the aperture stop 15. The stop shown in Figure 9A has a semicircular shape and it corresponds to large 6 for standard illumination. The stop shown in Figure 9B has an opening of semicircular shape, with a radius smaller than that Figure 9A, and it corresponds to small ó of standard illumination. The stop shown in Figure 9C has an opening of a shape defined by bisecting a ring by a straight line, and it corresponds to ring-zone illumination. The stop shown in Figure 9D has two circular openings, and it corresponds to quadrupole illumination.

It would be readily understood that, in any aperture stops, if it is folded back symmetrically with respect to the bottom side thereof, the shape of the opening corresponds to the shape of an ordinary aperture stop based on a circular shape.

Several opening patterns such as described above may be prepared and arrayed along a single line and they may be sequentially and interchangeably selected by use of an aperture stop driving system (not shown), by which a desired aperture shape can be chosen. Thus, various types of masks can be illuminated in an illumination mode best suited to each mask.

Referring back to Figure 1, the exposure method according to this embodiment will be explained in more detail. In Figure 1, the arcuate illumination region produced adjacent the opening of the arcuate slit 12 performs arcuate illumination of the reflection type mask 16 in the sense that light is incident on the reflection type mask 16 held on the mask stage 17, at a desired incidence angle to thereby form an arcuate illumination region thereon. The curvature center of this arcuate illumination region is approximately registered with the optical axis 18AX of the projection optical system 18.

The EUV reflection light from the arcuate-illuminated reflection mask 16 which bears information about a circuit pattern is projected to and imaged on a wafer 19 being coated with a photosensitive material, by the projection optical system 18 and at a magnification best suited for the exposure, whereby the circuit pattern is transferred thereto.

The wafer is fixedly held on the wafer stage 20 which has a function for moving vertically and horizontally as viewed in the drawing, and the motion thereof is controlled by means of a measuring device such as a laser interferometer, not shown. If the magnification of the projection optical system 18 is denoted by M, for example, the reflection type mask 16 may be scanningly moved in a direction parallel to the sheet of the drawing at a speed v while, on the other hand, the wafer 19 may be synchronously scanningly moved in a direction parallel to the sheet of the drawing at a speed v/M. The whole surface scanning exposure can be accomplished by it.

The projection optical system 18 comprises a plurality of multilayered-film reflection mirrors and it is designed so that a narrow arcuate region being abaxial with respect to the optical axis center 18AX provides good imaging performance. It is arranged to project the pattern of the reflection type mask 16 onto the wafer 19 surface in a reduced scale. It is a telecentric system on the image side (wafer side). As regards the object side (reflection type mask side), usually, it is non-telecentric to avoid physical interference with illumination light to be incident on the reflection type mask. For example, in this embodiment, the object-side principal ray is tilted by about 6 deg. with respect to the direction of the normal to the mask 16.

Next, referring to Figure 10, how to correct exposure non-uniformness in scanning exposure with use of the arcuate slit 12 will be explained in detail. In Figure 10, denoted at 1013 is an array of a large number of movable edge portions which have a function for partially changing the slit width 1011 of an arcuate slit 12. Denoted at 1011 is a slit opening for defining an arcuate illumination region, and denoted at 1012 is an arcuate irradiation region which can be produced by the integrator 11 and the arc forming optical system described hereinbefore. From this arcuate irradiation region, light that can pass through the slit opening 1011 can be extracted.

Here, in the scanning exposure and when the circuit pattern of the reflection type mask 16 is transferred to the wafer 19 in a reduced scale, if there is illuminance non-uniformness within the arcuate slit, it causes exposure non-uniformness as a result of scan exposure. In order to meet this problem, the slit width of only such portion the arcuate slit where the illuminance is relatively strong may be slightly narrowed by partially moving the movable edge portion 1013 by use of a driving system (not shown). Thus, by performing the scan exposure with minutely decreased light amount at that portion, being reduced as desired, as a result of integration throughout the whole exposure region the exposure can be accomplished with uniform intensity. During the scan exposure, as a matter of course, the arcuate slit 12 is held stationary with respect to the projection optical system 18.

In the embodiment described above, the invention has been explained with reference to an example wherein a reflection type integrator is used as a mirror. However, substantially the same advantageous results are obtainable when a stop like that of this embodiment is provided to a mirror disposed adjacent a pupil plane of an illumination system and having a plane reflection surface. In that occasion, it can be said that the aperture surface of the stop is disposed approximately perpendicularly to the line of intersection between the incidence plane of light incident on the mirror and the mirror reflection surface.

Furthermore, although in the embodiment described above a case wherein an aperture stop is used as a stop is considered, regarding a field stop for regulating an illumination region on the surface to be illuminated, a similar structure may be adopted.

In accordance with an illumination optical system of this embodiment of the present invention, good efficiency and uniform arcuate illumination can be achieved even by use of a structure having a relatively small number of mirrors (for example, without a masking imaging system). Thus, an illumination optical system quite suitable for use in an exposure apparatus is accomplished. With an exposure apparatus having the same, therefore, high resolution and stable image can be produced without a decrease of throughput.

[Embodiment 2]

Next, an embodiment of a device manufacturing method which uses an exposure apparatus of the first embodiment described above, will be explained.

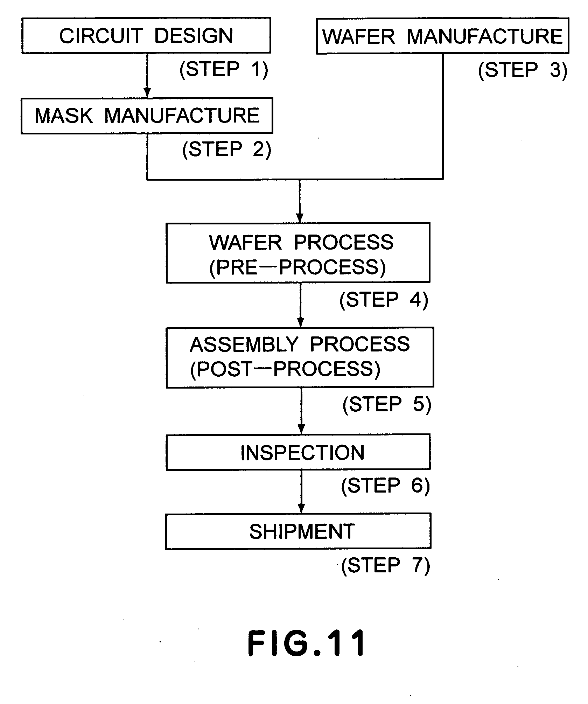

Figure 11 is a flow chart for explaining the procedure of manufacturing various microdevices such as semiconductor chips (e.g., ICs or LSIs), liquid crystal panels, or CCDs, for example. Step 1 is a design process for designing a circuit of a semiconductor device. Step 2 is a process for making a mask on the basis of the circuit pattern design. Step 3 is a process for preparing a wafer by using a material such as silicon. Step 4 is a wafer process which is called a pre-process wherein, by using the thus prepared mask and wafer, a circuit is formed on the wafer in practice, in accordance with lithography. Step 5 subsequent to this is an assembling step which is called a post-process wherein the wafer having been processed at step 4 is formed into semiconductor chips. This step includes an assembling (dicing and bonding) process and a packaging (chip sealing) process. Step 6 is an inspection step wherein an operation check, a durability check an so on, for the semiconductor devices produced by step 5, are carried out. With these processes, semiconductor devices are produced, and they are shipped (step 7).

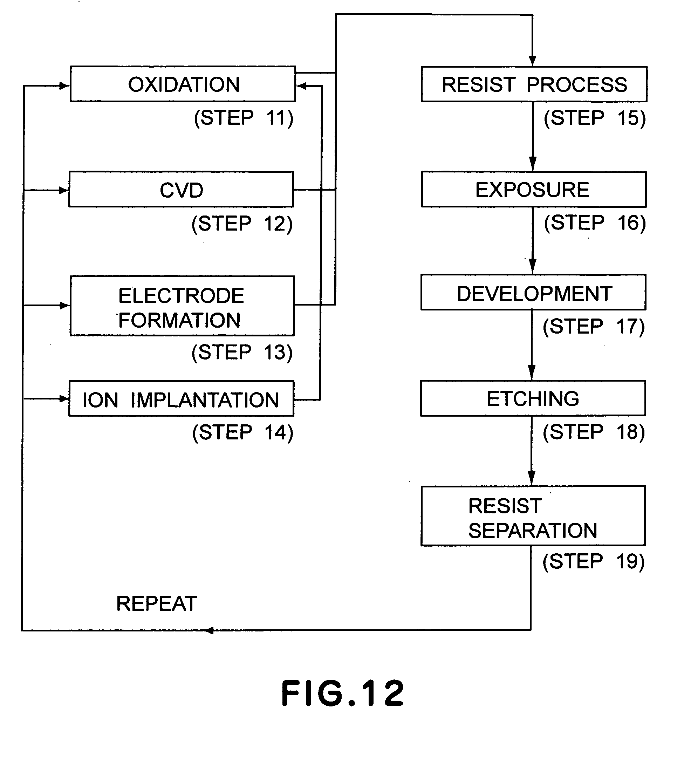

Figure 12 is a flow chart for explaining details of the wafer process. Step 11 is an oxidation process for oxidizing the surface of a wafer. Step 12 is a CVD process for forming an insulating film on the wafer surface. Step 13 is an electrode forming process for forming electrodes upon the wafer by vapor deposition. Step 14 is an ion implanting process for implanting ions to the wafer. Step 15 is a resist process for applying a resist (photosensitive material) to the wafer. Step 16 is an exposure process for printing, by exposure, the circuit pattern of the mask on the wafer through the exposure apparatus described above. Step 17 is a developing process for developing the exposed wafer. Step 18 is an etching process for removing portions other than the developed resist image. Step 19 is a resist separation process for separating the resist material remaining on the wafer after being subjected to the etching process. By repeating these processes, circuit patterns are superposedly formed on the wafer.

With these processes, high density microdevices can be manufactured with better yield.

While the invention has been described with reference to preferred embodiments thereof, the invention is not limited to them and many modifications and various changes are possible within the scope of the invention. For example, while embodiments have been described with reference to an illumination system and an exposure apparatus wherein EUV light of 13.5 nm is used, the present invention is applicable also to an illumination optical system and an exposure apparatus using different light, for example, extreme ultraviolet (EUV) light of a wavelength 200 nm to 10 nm or light of X-ray region. Particularly, with regard to light of 20 nm to 5 nm, there is no glass material that can be used for a transmission type (refractive) optical system, and a reflection optical system has to be used. Thus, the present invention can be applied effectively to an illumination optical system and an exposure apparatus that uses light of such wavelength region.

While the invention has been described with reference to the structures disclosed herein, it is not confined to the details set forth and this application is intended to cover such modifications or changes as may come within the purposes of the improvements or the scope of the following claims.

Disclosed is an illumination optical system and an exposure apparatus having the same. In one aspect, the illumination optical system illuminates a surface to be illuminated, with light from a light source, wherein it includes a mirror having a reflection surface, and a stop having an aperture surface disposed approximately perpendicularly to the reflection surface of the mirror.

## Claims

1. An illumination optical system for illuminating a surface to be illuminated, with light from a light source, comprising:

   a mirror having a reflection surface; and
   a stop having an aperture surface disposed approximately perpendicularly to the reflection surface of said mirror.

2. An illumination optical system according to Claim 1, wherein said mirror is a reflection type integrator for producing a plurality of secondary light sources by use of light from the light source.

3. An illumination optical system according to Claim 2, further comprising a first optical unit operable to transform the light from the light source into approximately parallel light and to project the same onto said reflection type integrator, and a second optical unit operable to superpose lights from the secondary light sources on an illumination region upon the surface to be illuminated.

4. An illumination optical system according to Claim 3, wherein said reflection type integrator has a reflection surface being disposed along a co-axis of said second optical unit.

5. An illumination optical system according to Claim 1, wherein said mirror is disposed so that a center of an illumination region, upon the reflection surface thereof, to be illuminated with light from the light source is at a predetermined plane being substantially in Fourier transform relation with the surface to be illuminated.

6. An illumination optical system according to Claim 1, wherein said stop is a stop for regulating a distribution shape of an effective light source.

7. An illumination optical system according to Claim 1, wherein said stop has an opening having a shape which is approximately the same as a shape of a half of a distribution shape of an effective light source, when the distribution shape of the effective light source is divided symmetrically with respect to a predetermined axis.

8. An illumination optical system according to Claim 7, wherein a portion of said stop that corresponds to the predetermined axis is disposed to be registered with or approximately registered with the reflection surface of said mirror.

9. An exposure apparatus, comprising:

an illumination optical system for illuminating a mask with light from a light source, said illumination optical system including a mirror having a reflection surface and a stop having an aperture surface disposed approximately perpendicularly to the reflection surface of said mirror; and
a projection optical system for projecting a pattern of the mask onto a substrate.

10. A device manufacturing method, comprising the steps of:

exposing a substrate by use of an exposure apparatus as recited in Claim 9; and
developing the exposed substrate.

11. An illumination optical system for illuminating a surface to be illuminated, with light from a light source, comprising:

a mirror having a reflection surface; and
a stop disposed adjacent the reflection surface of said mirror,

wherein light from the light source passes through an opening defined by the reflection surface of said mirror and said stop.

12. An illumination optical system according to Claim 11, wherein said mirror is a reflection type integrator for producing a plurality of secondary light sources by use of light from the light source.

13. An illumination optical system according to Claim 12, further comprising a first optical unit operable to transform the light from the light source into approximately parallel light and to project the same onto said reflection type integrator, and a second optical unit operable to superpose lights from the secondary light sources on an illumination region upon the surface to be illuminated.

14. An illumination optical system according to Claim 13, wherein said reflection type integrator has a reflection surface being disposed along a co-axis of said second optical unit.

15. An illumination optical system according to Claim 11, wherein said mirror is disposed so that a center of an illumination region, upon the reflection surface thereof, to be illuminated with light from the light source is at a predetermined plane being substantially in Fourier transform relation with the surface to be illuminated.

16. An illumination optical system according to Claim 11, wherein said stop is a stop for regulating a distribution shape of an effective light source.

17. An illumination optical system according to Claim 11, wherein said stop has an opening having a shape which is approximately the same as a shape of a half of a distribution shape of an effective light source, when the distribution shape of the effective light source is divided symmetrically with respect to a predetermined axis.

18. An illumination optical system according to Claim 17, wherein a portion of said stop that corresponds to the predetermined axis is disposed to be registered with or approximately registered with the reflection surface of said mirror.

19. An exposure apparatus, comprising:

an illumination optical system for illuminating a surface to be illuminated, with light from a light source, said illumination optical system including a mirror having a reflection surface, and a stop disposed adjacent the reflection surface of said mirror, wherein light from the light source passes through an opening defined by the reflection surface of said mirror and said stop; and
a projection optical system for projecting a pattern of the mask onto a substrate.

20. A device manufacturing method, comprising the steps of:

exposing a substrate by use of an exposure apparatus as recited in Claim 19; and
developing the exposed substrate.

**FIG.1**

10'

11a

## FIG.2A

## FIG.2B

FIG.3

FIG.4

FIG.5

# FIG.6

FIG.7

FIG.8A

FIG.8B

FIG.9A

FIG.9B

FIG.9C

FIG.9D

FIG.10

```
┌─────────────────────┐        ┌──────────────────────┐
│   CIRCUIT DESIGN    │        │  WAFER MANUFACTURE   │
└─────────────────────┘        └──────────────────────┘
        │ (STEP 1)                        (STEP 3)
        ▼
┌─────────────────────┐
│  MASK MANUFACTURE   │
└─────────────────────┘
         (STEP 2)
```

```
┌──────────────────────────┐
│     WAFER PROCESS        │
│    (PRE—PROCESS)         │
└──────────────────────────┘
          │ (STEP 4)
          ▼
┌──────────────────────────┐
│   ASSEMBLY PROCESS       │
│    (POST—PROCESS)        │
└──────────────────────────┘
          │ (STEP 5)
          ▼
┌──────────────────────────┐
│      INSPECTION          │
└──────────────────────────┘
          │ (STEP 6)
          ▼
┌──────────────────────────┐
│       SHIPMENT           │
└──────────────────────────┘
           (STEP 7)
```

# FIG.11

OXIDATION
(STEP 11)

CVD
(STEP 12)

ELECTRODE
FORMATION
(STEP 13)

ION IMPLANTATION
(STEP 14)

RESIST PROCESS
(STEP 15)

EXPOSURE
(STEP 16)

DEVELOPMENT
(STEP 17)

ETCHING
(STEP 18)

RESIST
SEPARATION
(STEP 19)

REPEAT

FIG.12